# EUROPEAN PATENT SPECIFICATION

(11) **EP 3 414 666 B1**
(45) Date of publication and mention of the grant of the patent: **04.11.2020**
(21) Application number: 17704117.5
(22) Date of filing: 14.01.2017
(51) Int. Cl.: G06F 13/16

(54) **SYSTEM AND METHOD FOR MULTI-TILE DATA TRANSACTIONS IN A SYSTEM ON A CHIP**
SYSTEM UND VERFAHREN FÜR TRANSAKTIONEN MIT MEHREREN TILES IN EINEM SYSTEM AUF EINEM CHIP
SYSTÈME ET MÉTHODE POUR DES TRANSACTIONS À MULTIPLES TUILES DANS UN SYSTÈME SUR PUCE

(30) Priority: 10.02.2016 US 201662293646 P; 23.06.2016 US 201662495577 P; 13.01.2017 US 201715406516
(43) Date of publication of application: 19.12.2018
(73) Proprietor: Qualcomm Incorporated, San Diego, CA 92121-1714 (US)
(72) Inventor: GADELRAB, Serag, San Diego, California 92121 (US); VARIA, Meghal, San Diego, California 92121 (US); WURJANTARA, Wisnu, San Diego, California 92121 (US); SUNG, Clara Ka Wah, San Diego, California 92121 (US); STERNBERG, Mark, San Diego, California 92121 (US); ANDRIJANIC, Vladan, San Diego, California 92121 (US); RINALDI, Antonio, San Diego, California 92121 (US); CHAMARTY, Vinod, San Diego, California 92121 (US); SINHA, Pooja, San Diego, California 92121 (US); WANG, Tao, San Diego, California 92121 (US); GRUBER, Andrew, San Diego, California 92121 (US)
(74) Representative: Wegner, Hans
(86) International application number: PCT/US2017/013599
(87) International publication number: WO 2017/139069

(56) References cited:
- SHAFIEE ALI ET AL: "MemZip: Exploring unconventional benefits from memory compression", 2014 IEEE 20TH INTERNATIONAL SYMPOSIUM ON HIGH PERFORMANCE COMPUTER ARCHITECTURE (HPCA), IEEE, 15 February 2014 (2014-02-15), pages 638-649, XP032606780, DOI: 10.1109/HPCA.2014.6835972 [retrieved on 2014-06-16]

## Description

### PRIORITY CLAIM AND CROSS REFERENCE

This application claims priority under 35 U.S.C §119(e) to U.S. Provisional Patent Application Serial No. 62/293,646, filed on February 10, 2016, entitled, "SYSTEM AND METHOD FOR MULTI-TILE DATA TRANSACTIONS IN A SYSTEM ON A CHIP," and to U.S. Provisional Patent Application Serial No. 62/495,577, filed on June 23, 2016, entitled, "SYSTEM AND METHOD FOR MULTI-TILE DATA TRANSACTIONS IN A SYSTEM ON A CHIP."

### DESCRIPTION OF THE RELATED ART

Portable computing devices ("PCDs") are becoming necessities for people on personal and professional levels. These devices may include cellular telephones, portable digital assistants ("PDAs"), portable game consoles, palmtop computers, and other portable electronic devices. PCDs commonly contain integrated circuits, or systems on a chip ("SoC"), that include numerous components designed to work together to deliver functionality to a user. For example, a SoC may contain any number of processing engines such as modems, central processing units ("CPUs") made up of cores, graphical processing units ("GPUs"), etc. that read and write data and instructions to and from memory components on the SoC.

The data and instructions are transmitted between the devices via a collection of wires known as a bus. A bus may include two parts in the forms of an address bus and a data bus; the data bus being used to actually transfer data and instructions between the processing engines and the memory components, and the address bus being used to transmit metadata that specifies a physical address within a memory component from/to which data or instructions are read/written.

The efficient use of bus bandwidth and memory capacity in a PCD is important for optimizing the functional capabilities of processing components on the SoC. Commonly, the utilization of memory capacity is optimized by compressing data so that the data requires less space in the memory. Data compression also increases bus bandwidth availability (bytes per memory access) for transactions coming from, or heading to, the memory component; however, compression reduces efficiency in accessing the memory component (bytes per clock cycle) because compressed transactions are relatively smaller transactions. Furthermore, compression requires the use of "padding" or "filler data" to round up transactions to integer multiples of the memory's minimum access length (MAL). Lots of small transactions coupled with the transmission of the filler data when working with compressed data presents an opportunity for improved efficiency in memory utilization.

The scientific article "MemZip: Exploring unconventional benefits from memory compression", of SHAFIEE ALI ET AL, 2014 IEEE 20TH INTERNATIONAL SYMPOSIUM ON HIGH PERFORMANCE COMPUTER ARCHITECTURE (HPCA), IEEE, (20140215), doi:10.1109/HPCA.2014.6835972, pages 638 - 649, describes that memory compression has been proposed and deployed in the past to grow the capacity of a memory system and reduce page fault rates. Compression also has secondary benefits: it can reduce energy and bandwidth demands. However, most prior mechanisms have been designed to focus on the capacity metric and few prior works have attempted to explicitly reduce energy or bandwidth. Further, mechanisms that focus on the capacity metric also require complex logic to locate the requested data in memory. The authors of said paper design a highly simple compressed memory architecture that does not target the capacity metric. Instead, it focuses on complexity, energy, bandwidth, and reliability. It relies on rank subsetting and a careful placement of compressed data and metadata to achieve these benefits. Further, the space made available via compression is used to boost other metrics - the space can be used to implement stronger error correction codes or energy-efficient data encodings. The best performing MemZip configuration yields a 45% performance improvement and 57% memory energy reduction, compared to an uncompressed non-sub-ranked baseline. Another energy-optimized configuration yields a 29.8% performance improvement and a 79% memory energy reduction, relative to the same baseline.

There is a need in the art for a system and method that addresses the inefficiencies associated transactions carrying lossless and lossy compressed data.

### SUMMARY OF THE DISCLOSURE

The present invention provides a solution according to the subject matter of the appended independent claims. Further variants are featured in the dependent claims.

### BRIEF DESCRIPTION OF THE DRAWINGS

In the drawings, like reference numerals refer to like parts throughout the various views unless otherwise indicated. For reference numerals with letter character designations such as "102A" or "102B", the letter character designations may differentiate two like parts or elements present in the same figure. Letter character designations for reference numerals may be omitted when it is intended that a reference numeral encompass all parts having the same reference numeral in all figures.
FIG. 1 illustrates the effects of compressing an image frame composed of multiple data sub-units or tiles;
FIG. 2 illustrates a compressed data transaction with a DRAM memory component that has a required minimum access length ("MAL") per transaction;
FIG. 3 illustrates a series of compressed data transactions associated with an exemplary image frame;
FIG. 4 illustrates the series of compressed data transactions from FIG. 3 when transmitted according to an exemplary multi-tile transaction ("MTT") embodiment configured to aggregate a pair of compressed tiles into a single transaction;
FIG. 5 illustrates the series of compressed data transactions from FIG. 3 when transmitted according to an exemplary multi-tile transaction ("MTT") embodiment configured to aggregate up to four compressed tiles into a single transaction;
FIG. 6A illustrates an exemplary embodiment of the solution configured for storing compressed tiles in a system that does not utilize multi-tile transactions;
FIG. 6B illustrates an exemplary configuration of metadata according to an embodiment of the solution for a system that allows multi-tile transactions that combine up to two compressed tiles into one transaction when feasible;
FIG. 6C illustrates an exemplary embodiment for a system that allows multi-tile transactions when the sum of the sizes of the compressed tiles is smaller than the footprint assigned by the system to store one uncompressed tile;
FIG. 7A depicts an MTT configuration of the solution where multiple compressed tiles occupy the footprint of an uncompressed tile;
FIG. 7B depicts the transformed data layout associated with a modified compressed tile that is larger than the original compressed tile;
FIG. 8 is a logical flowchart illustrating a method for managing compressed data with multi-tile transactions according to an embodiment of the solution;
FIG. 9 is a functional block diagram illustrating an exemplary, non-limiting aspect of a portable computing device ("PCD") in the form of a wireless telephone for implementing multi-tile transaction ("MTT") methods and systems;
FIG. 10 is a functional block diagram illustrating an embodiment of an on-chip system for managing compressed data stored in a DRAM component using multi-tile transactions ("MTT"); and
FIG. 11 is a schematic diagram illustrating an exemplary software architecture of the PCD of FIG. 9 for managing compressed data with multi-tile transactions.

### DETAILED DESCRIPTION

The word "exemplary" is used herein to mean serving as an example, instance, or illustration. Any aspect described herein as "exemplary" is not necessarily to be construed as exclusive, preferred or advantageous over other aspects.

In this description, the term "application" may also include files having executable content, such as: object code, scripts, byte code, markup language files, and patches. In addition, an "application" referred to herein, may also include files that are not executable in nature, such as documents that may need to be opened or other data files that need to be accessed.

In this description, reference to "DRAM" or "DDR" memory components will be understood to envision any of a broader class of volatile random access memory ("RAM") and will not limit the scope of the solutions disclosed herein to a specific type or generation of RAM. That is, it will be understood that various embodiments of the systems and methods provide a solution for managing transactions of data that has been compressed according to lossless and/or lossy compression algorithms and are not necessarily limited in application to compressed data transactions associated with double data rate memory. Moreover, it is envisioned that certain embodiments of the solutions disclosed herein may be applicable to DDR, DDR-2, DDR-3, low power DDR ("LPDDR") or any subsequent generation of DRAM.

As used in this description, the terms "component," "database," "module," "system," and the like are intended to refer generally to a computer-related entity, either hardware, firmware, a combination of hardware and software, software, or software in execution, unless specifically limited to a certain computer-related entity. For example, a component may be, but is not limited to being, a process running on a processor, a processor, an object, an executable, a thread of execution, a program, and/or a computer. By way of illustration, both an application running on a computing device and the computing device may be a component. One or more components may reside within a process and/or thread of execution, and a component may be localized on one computer and/or distributed between two or more computers. In addition, these components may execute from various computer readable media having various data structures stored thereon. The components may communicate by way of local and/or remote processes such as in accordance with a signal having one or more data packets (e.g., data from one component interacting with another component in a local system, distributed system, and/or across a network such as the Internet with other systems by way of the signal).

In this description, the terms "central processing unit ("CPU")," "digital signal processor ("DSP")," "graphical processing unit ("GPU")," and "chip" are used interchangeably. Moreover, a CPU, DSP, GPU or chip may be comprised of one or more distinct processing components generally referred to herein as "core(s)."

In this description, the terms "engine," "processing engine," "processing component" and the like are used to refer to any component within a system on a chip ("SoC") that transfers data over a bus to or from a memory component. As such, a processing component may refer to, but is not limited to refer to, a CPU, DSP, GPU, modem, controller, etc.

In this description, the term "bus" refers to a collection of wires through which data is transmitted from a processing engine to a memory component or other device located on or off the SoC. It will be understood that a bus consists of two parts - an address bus and a data bus where the data bus transfers actual data and the address bus transfers information specifying location of the data in a memory component (i.e., address and associated metadata). The terms "width" or "bus width" or "bandwidth" refers to an amount of data, i.e. a "chunk size," that may be transmitted per cycle through a given bus. For example, a 16-byte bus may transmit 16 bytes of data at a time, whereas 32-byte bus may transmit 32 bytes of data per cycle. Moreover, "bus speed" refers to the number of times a chunk of data may be transmitted through a given bus each second. Similarly, a "bus cycle" or "cycle" refers to transmission of one chunk of data through a given bus.

In this description, the term "portable computing device" ("PCD") is used to describe any device operating on a limited capacity power supply, such as a battery. Although battery operated PCDs have been in use for decades, technological advances in rechargeable batteries coupled with the advent of third generation ("3G") and fourth generation ("4G") wireless technology have enabled numerous PCDs with multiple capabilities. Therefore, a PCD may be a cellular telephone, a satellite telephone, a pager, a PDA, a smartphone, a navigation device, a smartbook or reader, a media player, a combination of the aforementioned devices, a laptop computer with a wireless connection, among others.

To make efficient use of bus bandwidth and DRAM capacity, data is often compressed according to lossless or lossy compression algorithms, as would be understood by one of ordinary skill in the art. Because the data is compressed, it takes less space to store and uses less bandwidth to transmit. However, because DRAM typically requires transactions to be an integer multiples of a minimum amount of data to be transacted at a time (a minimum access length, i.e. "MAL"), a transaction of compressed data may require filler data to round-up to an integer multiple of the minimum access length in bytes. Filler data or "padding" is used to "fill" the unused capacity in a transaction that must be accounted for in order to meet the integer multiple of MAL requirements.

For example, consider a 256-byte data tile transferred from a processing engine to a DRAM that has a 64-byte MAL. If transmitted in its uncompressed form, the 256-byte data transfer should ideally take 8 cycles of 32-byte data chunks to complete when transmitted on a bus with a 32-byte bandwidth. When compressed, the same data tile may be compressed on only 93 bytes thus requiring only require 3 cycles to transfer; however, to meet the integer-multiple of MAL requirements, an additional 35 bytes of padding or fill is added to the transaction in order to meet the 64-byte MAL of the DRAM. In this case the transactions containing the compressed tile would become 128Byte of which 93 Bytes are the compressed data and 35 bytes are padding/fill that do not contain any useful information . The need to include the padding/filler data may result in an effectively reduced capacity on the bus as a portion of the bandwidth used over the transaction went to transmitting the filler data instead of the compressed data.

Advantageously, embodiments of multi-tile transaction solutions combat the degradation in effective bus capacity by aggregating multiple compressed tiles into a single transaction, thereby increasing the size of each transaction, reducing the overall number of transactions in the system and reducing the ratio of padding bytes to useful compressed data in each transaction. A more detailed explanation of exemplary embodiments of multi-tile transaction solutions will be described below with reference to the figures.

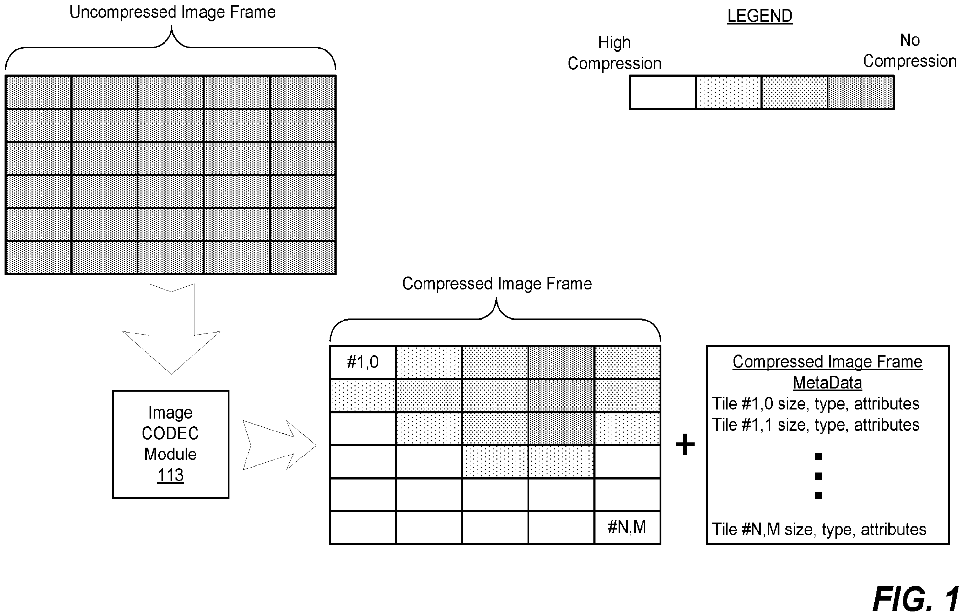

Turning to FIG. 1, illustrated are the effects of compressing an image frame composed of multiple data sub-units or tiles. In this description, the various embodiments are described within the context of an image frame made up of 256-byte tiles. Notably, however, it will be understood that the 256-byte tile sizes, as well as the various compressed data transaction sizes, are exemplary in nature and do not suggest that embodiments of the solution are limited in application to 256-byte tile sizes. Moreover, it will be understood that the reference to any specific minimum access length ("MAL") for a DRAM in this description is being used for the convenience of describing the solution and does not suggest that embodiments of the solution are limited in application to a DRAM device having a particular MAL requirement. As such, one of ordinary skill in the art will recognize that the particular data transfer sizes, chunk sizes, bus widths, MALs, etc. that are referred to in this description are offered for exemplary purposes only and do not limit the scope of the envisioned solutions as being applicable to applications having the same data transfer sizes, chunk sizes, bus widths, MALs etc.

Returning to the FIG. 1 illustration, an uncompressed image frame (aka, a "buffer") is depicted as being comprised of thirty uncompressed tiles, each of a size "K" as represented by a darkest shading. An exemplary size K may be 256 bytes, however, as explained above, a tile is not limited to any certain size and may vary according to application. As would be understood by one of ordinary skill in the art, the uncompressed image frame may be reduced in size, thereby optimizing its transfer over a bus and minimizing its impact on memory capacity, by a compressor block (depicted in FIG. 1 as Image CODEC Module 113) that applies a compression algorithm on a tile by tile basis. The result of the compression is a compressed image frame plus a metadata file, as can be seen in the FIG. 1 illustration. The compressed image frame is comprised of the tiles in the original, uncompressed image frame after having been subjected to a compression algorithm by the compression block 113.

In the uncompressed image frame, each tile may be of a size K, whereas in the compressed image frame each tile may be of a size K or less (K for no compression possible, K-1 bytes, K-2 bytes, K-3 bytes,..., K=1 byte). In the illustration, the various tiles that form the compressed image frame are represented by differing levels of shading depending on the extent of compression that resulted from the compression block having applied its compression algorithm to the data held by the given tile. Notably, the compression block 113 creates a companion buffer for a compressed image frame metadata, as would be understood by one of ordinary skill in the art. The compressed image frame metadata contains a record of the size, type and attributes for each compressed tile in the compressed image frame. Because DRAM access may be limited to units of the minimum access length MAL the size of a given compressed tile may be represented in the metadata as the number of ABSs required to represent the compressed tile size (e.g., 1 MAL, 2 MAL,...N MAL). This size description in the meta-data allows a future reader of the buffer to ask the memory for only the minimum required amount of data needed to decompress each tile back to the original size K.

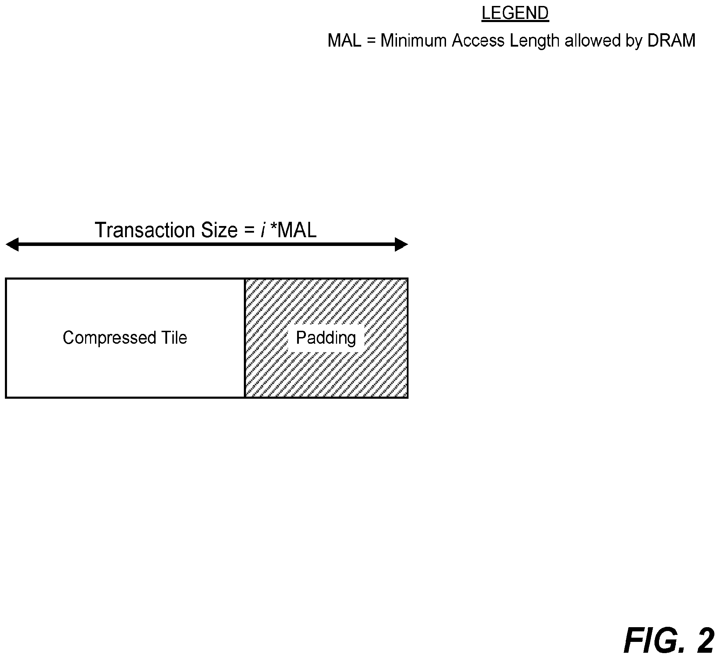

FIG. 2 illustrates a compressed data transaction with a DRAM memory component that meets the requirement for each transaction to be an integer-multiple of the minimum access length ("MAL") per transaction. As can be understood from the

FIG. 2 illustration, a compressed tile may be of a length that is less than an integer multiple of the minimum access length requirement for the DRAM in which it is stored. Consequently, a request for the compressed data requires a transaction that includes a certain amount of useless data, or "padding," needed to meet the integer-multiple of MAL requirement. The padding, which carries no information, is added to the compressed tile data to make the transaction size an integer multiple of the system MAL (*i**MAL). An exemplary MAL may be 32 bytes or 64 bytes, depending on the particular chip technology (such as LPDDR2, LPDDR3, LPDDR4, etc.) and the memory bus width (x16, x32, x64). As an example, a compressed tile having a 63 byte size may be padded with 1 byte of padding data in order to make a complete 64 byte transaction size (2x32B MAL or lx64B MAL). Similarly, a compressed tile having a 65 byte size may be padded with 31 bytes of the MAL is 32 Bytes (3x32B MAL) or 63 bytes of padding data if MAL is 64 bytes in order to make a complete 128 byte transaction size (2x64B MAL). Note that in the above examples, the difference in the compressed tile sizes is a mere 2 bytes; however, because the 65 byte compressed tile is over 64 bytes, a transaction of it must include significantly more padding.

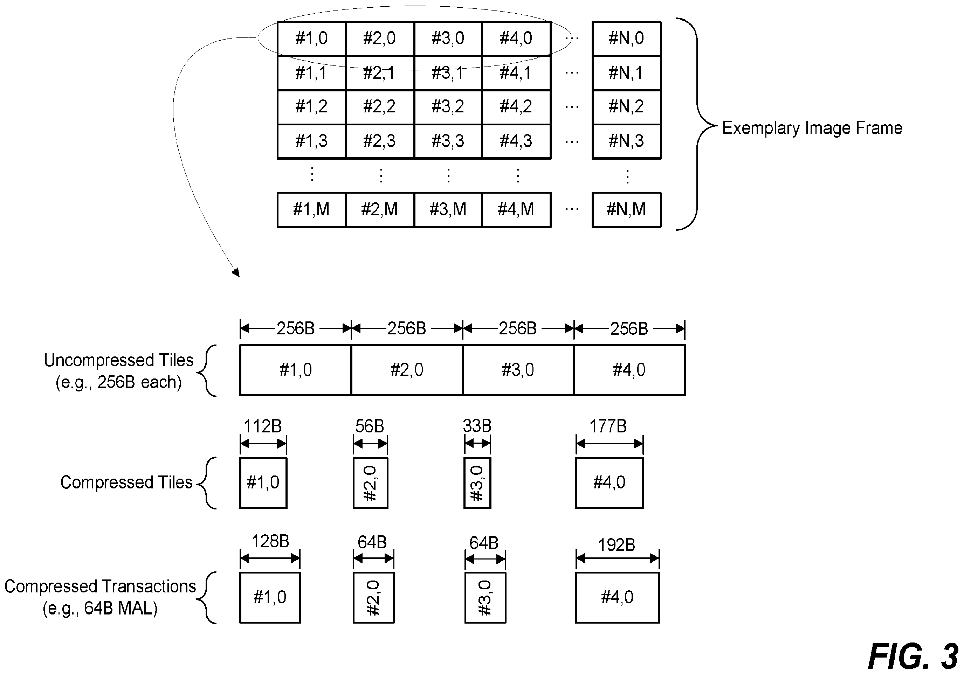

FIG. 3 illustrates a series of compressed data transactions associated with an exemplary image frame. The image frame is shown with "N" columns and "M" rows of tiles. The first four sequential tiles in the first row of tiles are illustrated in their uncompressed lengths, compressed lengths, and transaction lengths (compressed lengths plus padding) according to methods known in the art. The illustration is made within the context of the first four sequential tiles for convenience of illustration - the concepts depicted are relevant to groups of tiles other than the first four sequential tiles in a first row of tiles of an image frame, as would be understood by one of ordinary skill in the art.

Looking to the exemplary four sequential tiles in their uncompressed states, each tile (#1,0; #2,0; #3,0; #4,0) is of a 256 byte length (other lengths are envisioned). When compressed, the exemplary four sequential tiles have lengths of 112 bytes, 56 bytes, 33 bytes and 177 bytes, respectively. Assuming the MAL is 64 bytes, the transaction lengths for each of the exemplary four sequential tiles, respectively, may be 128 bytes (112 bytes compressed data plus 16 bytes padding), 64 bytes (56 bytes compressed data plus 8 bytes padding), 64 bytes (33 bytes compressed data plus 31 bytes padding) and 192 bytes (177 bytes compressed data plus 15 bytes padding). Notably, to transact all four of the exemplary sequential tiles, methods known in the art make four transactions - one for each compressed tile.

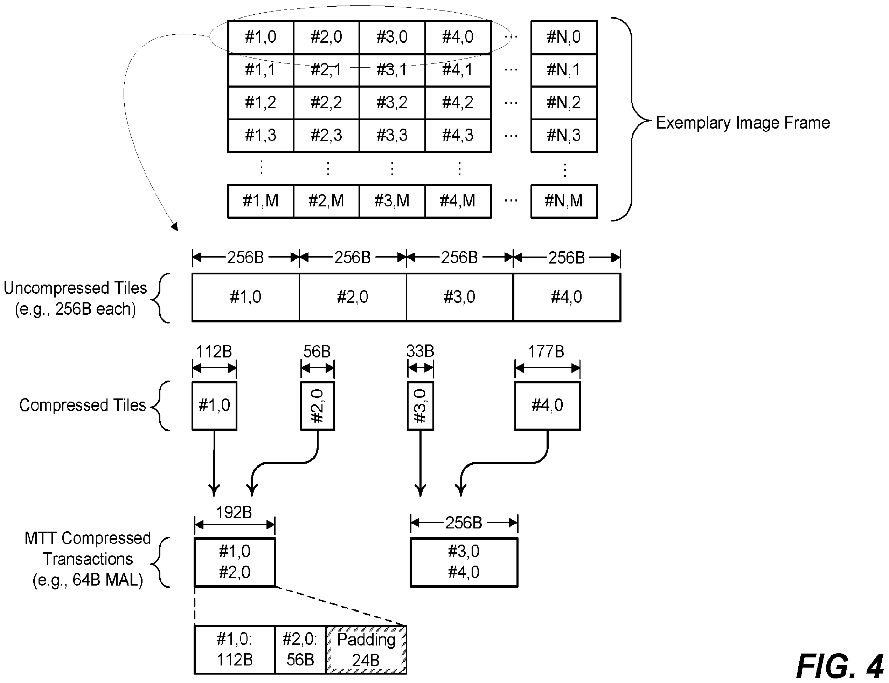

Turning to FIG. 4, illustrated is the exemplary series of compressed data transactions from FIG. 3 when transmitted according to an exemplary multi-tile transaction ("MTT") embodiment configured to aggregate a pair of compressed tiles into a single transaction. Advantageously, because MTT solutions aggregate a group of compressed tiles when appropriate, the number of transactions required to transact all tiles of a compressed image frame may be reduced when compared to prior art methods. Also, the ratio of padding bytes to compressed data bytes required to meet the integer-multiple MAL requirement when transacting the compressed tiles of a compressed image frame may be reduced for a larger MTT, thereby optimizing the system performance in two ways. First the bus bandwidth utilization is increased by virtue of the lowered number of padding bytes for each data byte transacted. Secondly, by increasing the average size of each transaction and reducing the overall number of transactions, the DRAM access efficiency is increased. MTT solutions may be applicable to any lossless or lossy compression method that generates variably sized compression blocks. As will become more apparent from further description and figures, MTT solutions aggregate multiple compressed tiles into one or more transactions to a DRAM memory device and, by doing so, may improve the effectiveness of a compression algorithm by generating a relatively higher compression ratio (results in higher DRAM utilization), increasing the average transaction size (results in improved DRAM efficiency), and reducing the transaction count for a given block of data (results in improved DRAM throughput).

Notably, although exemplary MTT embodiments described herein make use of sequential tiles in a row, MTT embodiments are not limited to aggregating sequential tiles in a row of an image frame. Rather, it is envisioned that MTT embodiments may aggregate tiles according to any logical grouping such as, but not limited to, sequential tiles in a row, sequential tiles in a column, contiguous tiles in an area, etc.

Returning to the FIG. 4 illustration, the MTT embodiment is configured to aggregate up to two sequential tiles, such as tiles #1,0 and #2,0. Consistent with that which was described relative to FIG. 3, the exemplary four sequential tiles in their uncompressed states (#1,0; #2,0; #3,0; #4,0) are each of a 256 byte length (other lengths are envisioned). When compressed, the exemplary four sequential tiles have lengths of 112 bytes, 56 bytes, 33 bytes and 177 bytes, respectively. Assuming the MAL is 64 bytes, the exemplary MTT solution examines the lengths of the first two sequential tiles (#1,0 and #2,0) and determines if the compressed tiles may be combined into a single transaction. In the illustration, because tiles #1,0 (112 bytes) and #2,0 (56 bytes) may be combined into a single transaction of 192 bytes (112 bytes plus 56 bytes plus 24 bytes of padding) that is an integer multiple of the 64 byte MAL (3 x 64 = 192), the MTT solution aggregates the first two compressed tiles into a single large transaction, thereby avoiding the need to issue two smaller transactions. Similarly, the exemplary MTT solution illustrated in FIG. 4 may combine tiles #3,0 (33 bytes) and #4,0 (177 bytes) into a single large 256 byte transaction, thereby avoiding two smaller transactions.

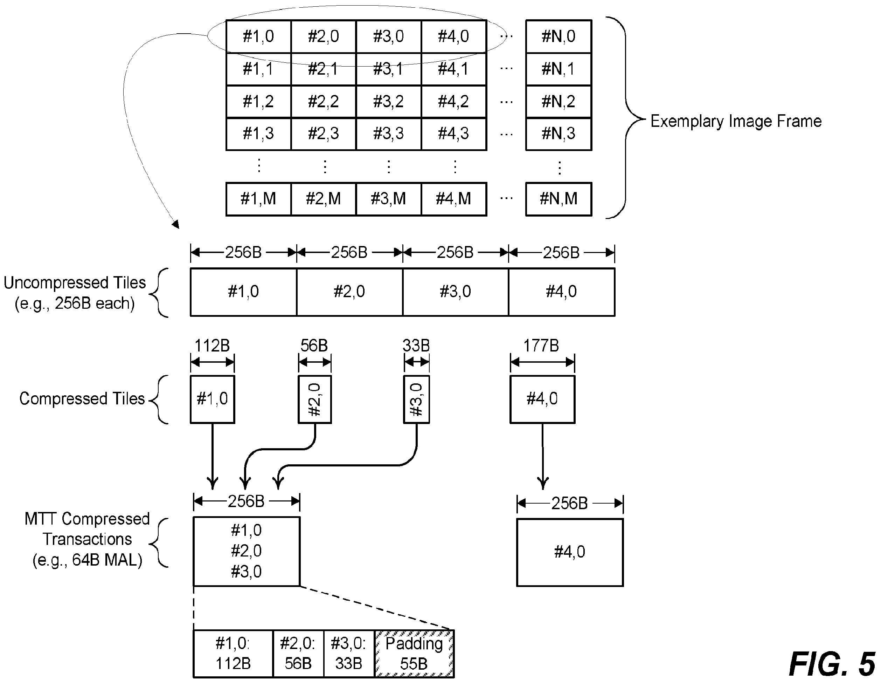

It is envisioned that certain MTT embodiments may look to combine more than two tiles into a single transaction. For example, FIG. 5 illustrates the series of compressed data transactions from FIG. 3 when transmitted according to an exemplary multi-tile transaction ("MTT") embodiment configured to aggregate up to four compressed tiles into a single transaction. As can be seen from the FIG. 5 illustration, the compressed tiles #1,0 (112 bytes), #2,0 (56 bytes), and #3,0 (33 bytes) may be combined into a single, large 256 byte transaction while tile #4,0 (177 bytes) is also transacted in its own 256 byte transaction. In this way, transactions to and from the DRAM may be aggregated such that the most efficient, optimum transaction length of 256 bytes is used more often than would be the case with prior art methods.

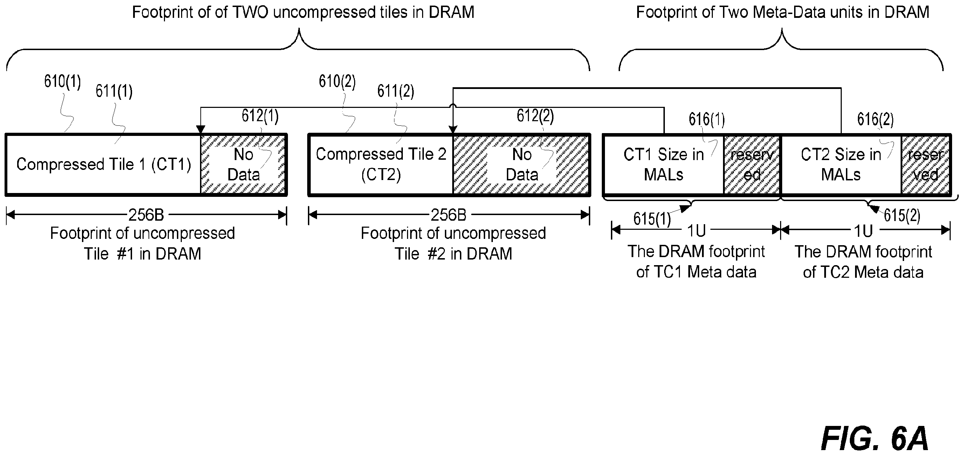

FIG. 6A illustrates an exemplary configuration for storing the compressed tiles CT1 610(1) and CT2 610(2) in a system that does not utilize multi-tile transactions. In the Figure the boxes labeled CT1 and CT2 include the padding data required to meet the MAL requirement of the system. As illustrated in FIG. 6A, compressed tile CT1 611(1) occupies a portion of the space allocated to uncompressed tile #1 and Compressed Tile CT2 611(2) occupies a portion of the space allocated to uncompressed tile #2. Due to compression, CT1 611(1) data does not occupy the entire DRAM space allocated for uncompressed tile #1 and the unused remaining space shown as boxes 612(1) is marked with the label "No Data". A similar situation occurs for CT2 611(2). The boxes labeled "No Data" 612(1) and 612(2) represent the DRAM locations that would have been occupied by uncompressed data but that are not written to when CT1 611(1) or CT2 611(2) are written to DRAM due to the fact that the length of the padded compressed tile in units of MAL may be less than the size of memory footprint allocated to the uncompressed tile. Each compressed tile therefore occupies the space equal or less than the allocated space of an uncompressed tile in the DRAM. By reducing the amount of data written into the DRAM per tile, compression yields both power savings and an increase in available DRAM bandwidth.

FIG. 6A also demonstrates a scenario where compression ratio of CT2 611(2) is higher than that of CT1 611(1) and thus the size of the "No Data" region associated with CT2 611(2) is larger than that of the similarly labeled region associated with CT1 611(1). FIG. 6A also represents an exemplary configuration of metadata for the compressed tiles (CT1 and CT2) in a system that does not utilize multi-tile transactions. The meta-data 615(1) and 615(2) for each of the compressed tiles occupies a unit of space (U) in the DRAM. The size of said unit is must be larger than or equal of the number of bits required to represent the maximum size each compressed tile in units of MAL. For example, if the largest transaction allowed in the system is 256 bytes and the MAL is 64 bytes, then only 2 bits are required to represent the length of the compressed tile. Alternatively for the same system with a largest transaction allowed in the system is 256 bytes, if the MAL was to be reduced to 32Byte then a minimum of 3 bits of meta-data are required to represent the length of the compressed tile. In FIG. 6A, each meta-data entry is assumed to be of length U in the DRAM where U is a number of bits required to represent the size of each compressed tile in units of MAL plus a reserved number for bits for future expansion. The field 616(1) labeled "CT1: Size in MALs" represents the size of the compressed CT1 in multiples of MAL. When the value of field 616(1) is multiplied by the MAL value in bytes, the result is the size of the compressed tile in bytes as shown by the arrows connecting the field 616(1) "CT1: size in MALs" to the end of the compressed tile CT1 611(1) in FIG. 6A. Note that while the size of each compressed tiles will vary because the achieved compression ratio is a function of the pixel content of the individual tile, the number of bits required to store the size of the compressed tiles must be large enough to accommodate the number of bits required to represent the value of the uncompressed tile in units of MAL in order to accommodate the situation where the length of the compressed tile plus padding is equal to the length of the uncompressed tile.

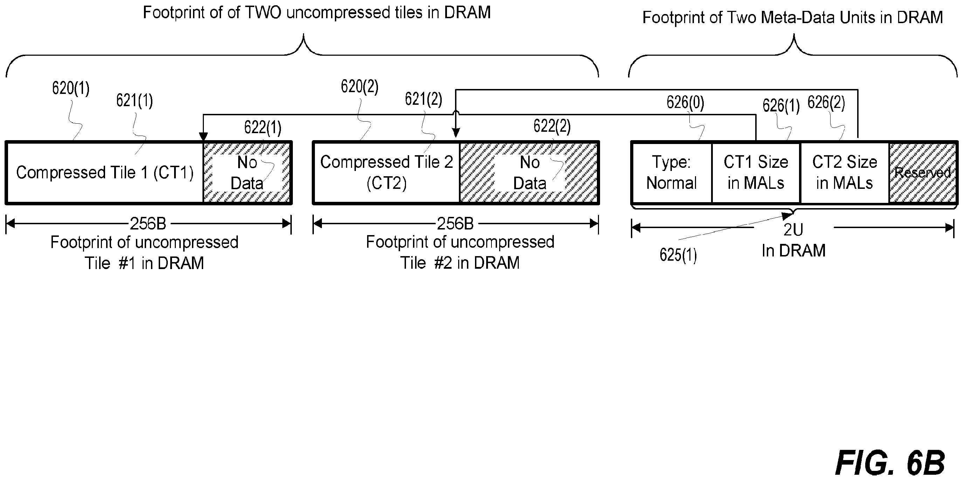

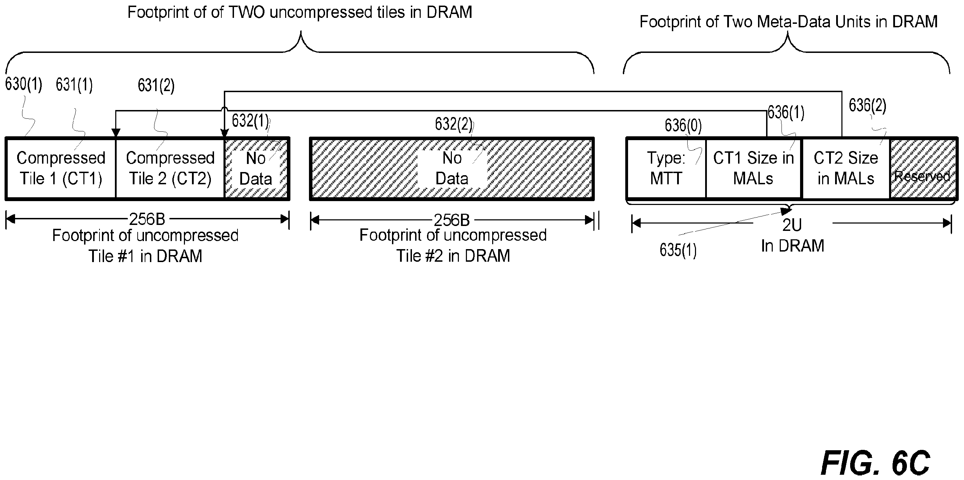

FIG. 6B illustrates an exemplary configuration of metadata for a system that allows multi-tile transactions according to an embodiment of the solution configured to combine up to two compressed tiles into one transaction when feasible (similar to Fig 4). In this case the DRAM locations (footprint) (615(1) and 615(2)) allotted for the meta-data of the two consecutive tiles are combined into a single field 625(1) that stores the metadata which describes content stored in the DRAM locations for uncompressed tile #1 620(1) and uncompressed tile #2 620(2). In the exemplary situation depicted in FIG. 6B, the sum of the sizes of the compressed tile TC1 621(1) and the compressed Tile (CT2) is larger than the footprint assigned by the system to store one uncompressed tile (256B in the example showing in FIG. 6). In this case, where the size of the two compressed tiles is larger than the footprint assigned by the system to store one uncompressed tile, the producer of the compressed tiles inserts each compressed tile at the start of the corresponding location for the uncompressed tile. In the example shown in FIG. 6B the producer issues two write transactions to the DRAM. The first write transaction writes compressed tile (CT1) 621(1) at the start of the location assigned to uncompressed Tile #1 620(1). The second write transaction writes compressed tile (CT2) 621(2) at the start of the location assigned to uncompressed Tile 2 620(2). Note that two separate transactions are required (one for each compressed tile) to ensure that DRAM bandwidth and power is not wasted by writing to the "No Data" part 622(1).

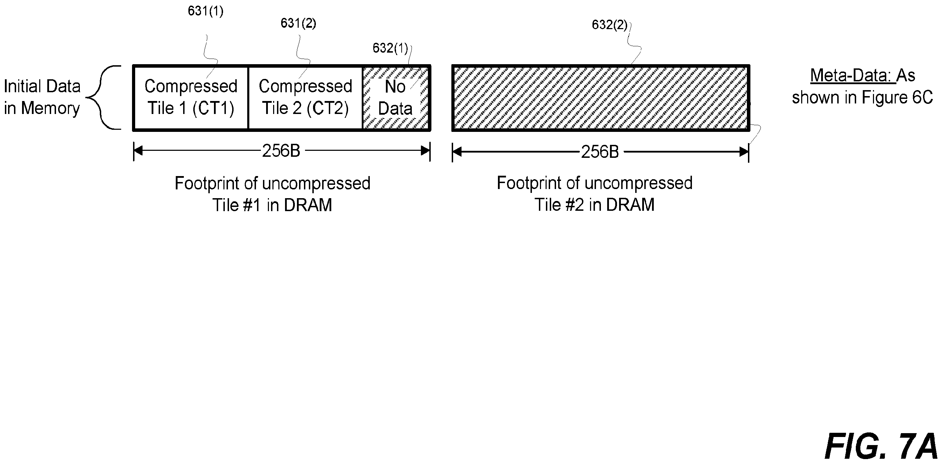

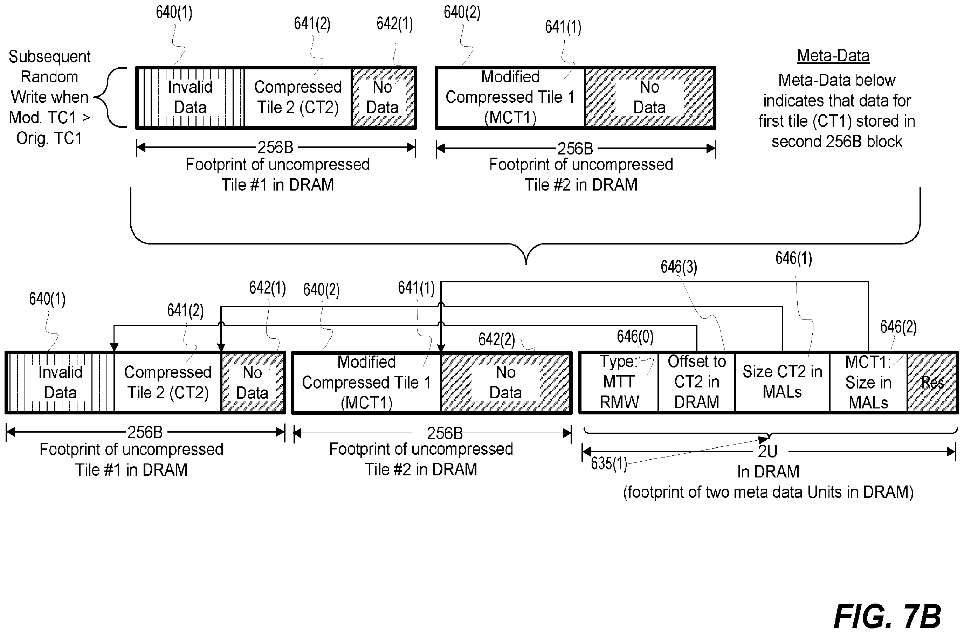

The metadata for CT1 and CT2 in FIG. 6B are located in a single metadata field 625(1). The length of single metadata field 625(1) may be double the length (2U) of each the metadata fields used to describe the compressed data tiles 611(1) and 611(2) in systems that do not implement multi tile transactions. Alternatively the size of the metadata for systems implementing multi-tile transaction may be larger than 2U if more bits are required to describe the compressed tiles (not shown in in FIG. 6B). FIG. 6B shows that the metadata field of the system implementing multi-tile transactions is composed of a header subfield 626(0) that describes the arrangement of the compressed tiles in memory. There are three possible values for the header field 626(0): "Normal" as shown in FIG. 6B, "Multi tile transaction (MTT)" as shown in FIG. 6C and "MMT with "Read-modify-Write (MMT-RMW)" as shown in Fig 7. The header field 626(0) in FIG. 6B indicates a "normal" configuration where the size of the two compressed tiles is larger than the footprint assigned by the system to store one uncompressed tile and that the producer of the compressed tiles inserted each compressed tile at the start of the corresponding location for the uncompressed tile.

Any entity that wants to read the compressed tiles 621(1) or 621(2) may first read the metadata 625(1) to ascertain the header field type. For a "Normal" header field, such as shown in FIG. 6B, the reader may issue one read transaction to the memory for each of the compressed tiles CT1 or CT2. There is no possibility for issuing one transaction to read both CT1 and CT2 in FIG. 6B because the memory footprint occupied by CT1 621(1), the No Data Field 622(1) and CT2 621(2) would be larger than the maximum transaction length allowed by the system (256B in this case). Therefore, the benefit of multi-tile transitions is not realized in the case depicted in FIG. 6B.

FIG. 6C illustrates an exemplary case for a system that allows multi-tile transaction where the sum of the sizes of the compressed tile TC1 631(1) and the compressed tile TC2 631(2) is smaller than the footprint assigned by the system to store one uncompressed tile (256B in the example showing in Fig.6). In this scenario, where the size of the two compressed tiles is smaller than the footprint assigned by the system to store one uncompressed tile, the producer of the two compressed tiles concatenates the two compressed tiles into a single transaction and issues a single transaction to the DRAM which inserts the concatenated compressed tiles at the start of the corresponding location for the uncompressed tile CT1. The location of the uncompressed tile CT2 is not written into as denoted by the No Data label 632(2). In doing so the producer issues a single transaction to the DRAM that conveys the data for both CT1 631(1) and CT2 631(2). This single transaction contains multiple tiles (two) and is therefore called a "multi-tile transaction". By combining the data from two tiles into a single transaction the system saves DRAM power and bandwidth as well as reduce the number of transactions flowing through the system.

Advantageously, the producer of the data in FIG. 6C may also produce a single corresponding meta-data field 645(1) as shown in FIG. 6C that describes the size and location of CT1 631(1) and CT2 631(2). The length of single metadata field 645(1) may be double the length (2U) of each of the metadata fields used to describe the compressed data tiles 611(1) and 611(2) in systems that do not implement multi-tile transactions. The size and organization of the metadata field 635(1) in FIG. 6C may be identical to the size and organization of the metadata field 625(1) in FIG. 6B as both cases may coexist in systems implementing multi-tile transaction. The Type field 636(0) of this associated meta-data contains the code for "Multi tile transaction" which is (MTT) because the producer is able to combine CT1 and CT2 into a single transaction and the data is located in the memory at the location of the uncompressed Tile #1. The metadata also contains a field that describes the size of CT1 in units of MAL 636(1) and the size of CT2 636(2) in units of MAL. This metadata field is written into the DRAM by the producer in the location that would have been occupied by the metadata fields for CT1 and CT2.

Once an MTT is written into the DRAM as shown in FIG. 6C random reads are possible based on the data and metadata organization shown in FIG. 6. Any entity that wants to read the compressed tiles 631(1) or 631(2) must first read the metadata 635(1) to ascertain the header field type. For a "MTT" header field as shown in in FIG. 6B, for example, the reader may issue one read transaction to the memory to fetch both compressed tiles CT1 631(1) and CT2 631(2) by asking the DRAM to read a the data starting from the starting point of the uncompressed tile #1 and with a length equal to the sum of CT1 631(1) and CT2 631(2) in units of MAL. This saves both power and bandwidth in the system as both tiles are fetched with a single transaction. Alternatively, the reader may read CT1 631(1) only by issuing one transaction that starts reading at the starting point of the uncompressed tile #1 with a length equal to the size of CT1 631(1) in units of MAL. Alternatively, the reader may read CT2 631(2) only by issuing one transaction that starts reading at the starting point of the uncompressed tile #1 plus the length to the size of CT1 631(1) in units of MAL. This read transaction length is equal to the size of CT2 631(2). This it is clear to a practitioner of the art that the organization of data and meta-data disclosed herein allows a reduction of the number of transactions issued to the memory without loss in flexibility in terms of being able to randomly read or write either compressed tiles.

Random writes are also possible for the compressed tiles that are already written to the DRAM as a MTT shown in FIG. 6C. Consider, for example, the case where the second tile CT2 is to be modified or if a new compressed tile CT2 is created. If a new compressed tile CT2 is created and size of the newly created/modified CT2 is smaller than or equal to the sum of the original CT2 631(2) and the original No Data field 632(1), then the new CT2 may overwrite the older CT2 using a single transaction to DRAM that writes the new CT2 at the starting point of the older CT2. The metadata filed 635(2) may then be modified by the writer to reflect the new size of CT2 without any other changes to the metadata 635(1). If, however, the size of the new CT2 is larger than the sum of the original CT2 631(2) and the original No Data field 632(1), then it will not fit in the same footprint of the uncompressed tile #1 as shown in FIG. 6C. In that case, the multi-tile transaction is not viable. The producer of the new CT2 should then revert to using the organization of FIG. 6B by writing the modified CT2 in the footprint of the uncompressed tile #2 using a single transaction. The associated metadata for the older CT1 and the newer CT2 would be modified by the writer to resemble 625(1) where the size of the new CT2 is placed into 626(2), the size of the older CT1 is in 626(1) and the Type field 626(0) is set to Normal. Advantageously, the content of CT1 is never moved or touched and remain in its location.

Random writes may also be possible for a new or modified CT1 tiles that are already written to the DRAM as a MTT shown in FIG. 6C. Consider, for example, the case where a the new compressed tile CT1 is created and the size of the newly created/modified CT1 is smaller than or equal to the sum of the original CT1 631(1). In that case the new CT1 may overwrite the older CT1 using a single transaction to DRAM that writes the new CT1 at the starting point of the older CT1. The metadata filed 635(2) is not modified by the writer and so field CT1 Size in MALs 636(1) would contain the older, larger size for CT1. This is needed because the older size of CT1 636(1) reflects the starting point of CT2 631(2) and therefore cannot be modified. While this represents a small inefficiency when reading the smaller CT1, the use MTT to use one transaction for reading CT1 and CT2 is a much higher bandwidth and power savings.

If the size of the new CT1 is larger than the original CT1 631(1), then it cannot be written into the same location as the original CT1 631(1) because it would overwrite the existing CT2 data 631(2). In this the data and metadata layout showing in FIG. 7 may be used with the Type field set to "Read-modify-Write (MMT-RMW)". FIG. 7A shows the MTT configuration where CT1 and CT2 occupy the footprint of the uncompressed tile #1 (and is a copy of the data portion of FIG. 6C). FIG. 7B shows the transformed data layout once CT1 is modified when the size of the modified CT1 (MCT1) 641(1) is larger than the original CT1 631(1). As depicted in the FIG. 7B, the writer of the modified CT1 (MCT1) writes the data of MCT1 in the footprint of the uncompressed Tile #2 640(2) and the data that was previously occupied by CT1 in the footprint of the uncompressed Tile #1 is marked as Invalid Data as shown in FIG. 7B. The metadata 635(1) for this organization has to reflect the fact that CT2 641(2) is located in the footprint of the uncompressed Tile #1 while the MCT1 640(2) is located in the footprint of the uncompressed tile #2. The Type field 646(0) of the mea data is set to MTT-RMMW to indicate that it represents two tiles that were previously of type MTT and have since had CT1 modified to an MCT1 where the MCT1 size is larger than the original size of CT1. The second field in the meta-data 646(3) is the size of the original CT1 in MALs which provides the offset to the location of the CT2 within the footprint of the uncompressed Tile #1 in DRAM.

Notably, 646(3) field may be used by a reader to locate starting byte of the CT2 within the footprint of the uncompressed Tile #1 in DRAM. The third field 646(1) in the meta-data is the size of CT2 in MALs which allows a reader that is accessing CT2 to issue correct size for the read instruction to the DRAM. The fourth field of the metadata 646(2) is the size of the modified CT1 (MCT1) so that a reader that needs to access MCT1 may issue a read transaction that reads a number of MALs equal to 646(2) starting at the start of the footprint of the uncompressed Tile #2 in DRAM.

The above algorithm/method demonstrates combining of up to two compressed tiles into a multi-tile transaction. This algorithm may be easily expanded to increase the maximum number of compressed tiles in one transaction to beyond two (three, four...etc) This may require a commensurate increase in the size of metadata for such systems.

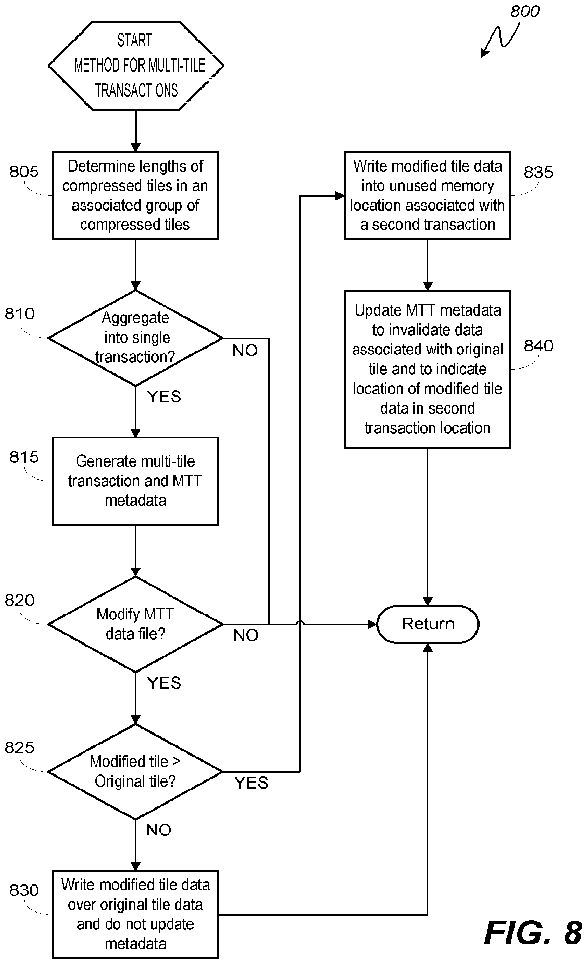

FIG. 8 is a logical flowchart illustrating a method 800 for managing compressed data with multi-tile transactions according to an embodiment of the solution. Specific functionality, as well as variations thereof, captured by blocks within exemplary method 800 have been described above in detail relative to the previous figures. Beginning at block 805, the lengths of compressed tiles in a group may be determined. As explained above, it is envisioned that the size and configuration of a group of compressed tiles may vary according to the MTT embodiment. For example, a certain MTT embodiment may seek to aggregate pairs of compressed tiles that are sequentially ordered in a row of an image frame. Moreover, a certain other MTT embodiment may seek to aggregate up to four compressed tiles that are contiguous in an area of an image frame (e.g., tiles #1,0; #1,1; #2,0; #2,1).

At decision block 810, an MTT embodiment may determine if tiles in the group may be combined into a single transaction (determination based on sums of the tile lengths). If no combination of the tiles is possible, or desirable, the "NO" branch is followed and the method 800 returns. If combination of tiles in the group into a single transaction is possible, and desirable, the "YES" branch is followed to block 815 and multi-tile transaction is generated to include compressed tile data from multiple tiles in the group. Metadata associated with the MTT transaction is generated so that each compressed tile in the MTT transaction may be randomly accessed and updated.

At decision block 820, the method 800 may recognize whether a compressed tile previously stored in a memory space associated with a MTT transaction requires updating. If not, then the "NO" branch is followed and the method 800 returns. If updating of compressed data previously aggregated into a MTT transaction is required, then the "YES" branch is followed to decision block 825.

At decision block 825, if the modified compressed file is equal in size to, or smaller than, the original compressed file, then the "NO" branch is followed to block 830 and the modified data is written over the original compressed data. If, however, the modified compressed file is larger in size than the original compressed file, then the "YES" branch is followed to block 835.

At block 835, the modified data may be written into an unused memory location associated with a second transaction that was previously not needed as a result of the multi-tile aggregation. The method 800 continues to block 840 and the metadata associated with the MTT transaction is updated to reflect that the original data of the compressed tile stored per the first transaction is invalid and that the "fresh" modified data for the compressed tile may be found in the memory space associated with the previously unused, second transaction. The method 800 returns.

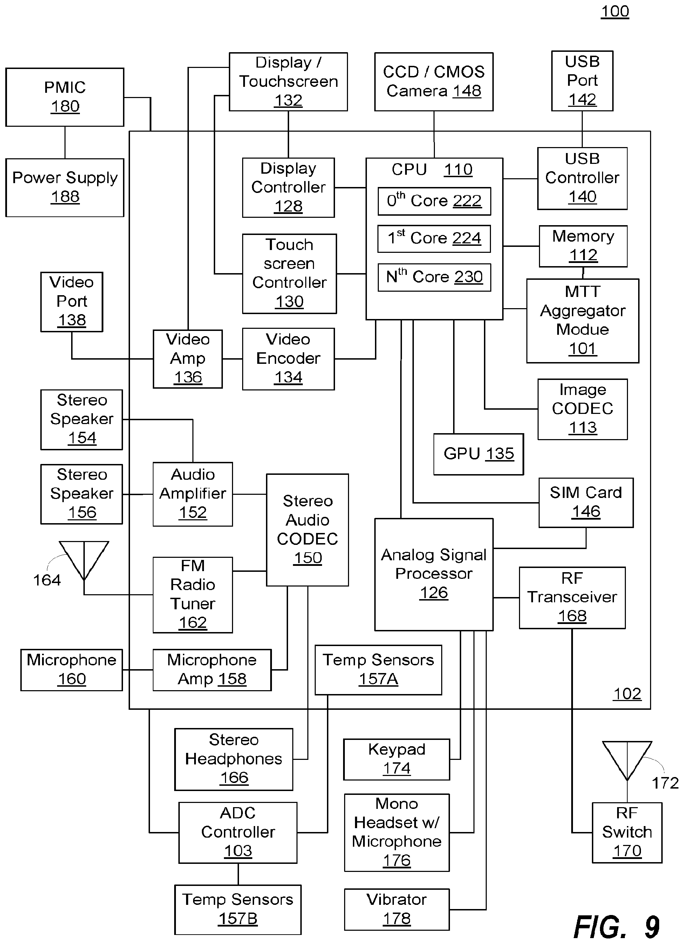

FIG. 9 is a functional block diagram illustrating an exemplary, non-limiting aspect of a portable computing device ("PCD") 100 in the form of a wireless telephone for implementing multi-tile transaction ("MTT") methods and systems. As shown, the PCD 100 includes an on-chip system 102 that includes a multi-core central processing unit ("CPU") 110 and an analog signal processor 126 that are coupled together. The CPU 110 may comprise a zeroth core 222, a first core 224, and an Nth core 230 as understood by one of ordinary skill in the art. Further, instead of a CPU 110, a digital signal processor ("DSP") may also be employed as understood by one of ordinary skill in the art.

In general, multi-tile transaction ("MTT") aggregator module 101 may be formed from hardware and/or firmware and may be responsible for combining multiple compressed tiles of an image frame into a single transaction. It is envisioned that write bursts to a DRAM memory 115 (generally labeled 112 in the FIG. 9 illustration), for instance, may be compressed according to a lossless or lossy compression algorithm executed by an image CODEC module 113 and combined into single multi-tile transactions by the MTT aggregator 101.

As illustrated in FIG. 9, a display controller 128 and a touch screen controller 130 are coupled to the digital signal processor 110. A touch screen display 132 external to the on-chip system 102 is coupled to the display controller 128 and the touch screen controller 130. PCD 100 may further include a video encoder 134, e.g., a phase-alternating line ("PAL") encoder, a sequential couleur avec memoire ("SECAM") encoder, a national television system(s) committee ("NTSC") encoder or any other type of video encoder 134. The video encoder 134 is coupled to the multi-core CPU 110. A video amplifier 136 is coupled to the video encoder 134 and the touch screen display 132. A video port 138 is coupled to the video amplifier 136. As depicted in FIG. 9, a universal serial bus ("USB") controller 140 is coupled to the CPU 110. Also, a USB port 142 is coupled to the USB controller 140. A memory 112, which may include a PoP memory, a cache 116, a mask ROM / Boot ROM, a boot OTP memory, a type DDR of DRAM memory 115 (see subsequent Figures) may also be coupled to the CPU 110. A subscriber identity module ("SIM") card 146 may also be coupled to the CPU 110. Further, as shown in FIG. 9, a digital camera 148 may be coupled to the CPU 110. In an exemplary aspect, the digital camera 148 is a charge-coupled device ("CCD") camera or a complementary metal-oxide semiconductor ("CMOS") camera.

As further illustrated in FIG. 9, a stereo audio CODEC 150 may be coupled to the analog signal processor 126. Moreover, an audio amplifier 152 may be coupled to the stereo audio CODEC 150. In an exemplary aspect, a first stereo speaker 154 and a second stereo speaker 156 are coupled to the audio amplifier 152. FIG. 9 shows that a microphone amplifier 158 may be also coupled to the stereo audio CODEC 150. Additionally, a microphone 160 may be coupled to the microphone amplifier 158. In a particular aspect, a frequency modulation ("FM") radio tuner 162 may be coupled to the stereo audio CODEC 150. Also, an FM antenna 164 is coupled to the FM radio tuner 162. Further, stereo headphones 166 may be coupled to the stereo audio CODEC 150.

FIG. 9 further indicates that a radio frequency ("RF") transceiver 168 may be coupled to the analog signal processor 126. An RF switch 170 may be coupled to the RF transceiver 168 and an RF antenna 172. As shown in FIG. 9, a keypad 174 may be coupled to the analog signal processor 126. Also, a mono headset with a microphone 176 may be coupled to the analog signal processor 126. Further, a vibrator device 178 may be coupled to the analog signal processor 126. FIG. 9 also shows that a power supply 188, for example a battery, is coupled to the on-chip system 102 through a power management integrated circuit ("PMIC") 180. In a particular aspect, the power supply 188 includes a rechargeable DC battery or a DC power supply that is derived from an alternating current ("AC") to DC transformer that is connected to an AC power source.

The CPU 110 may also be coupled to one or more internal, on-chip thermal sensors 157A as well as one or more external, off-chip thermal sensors 157B. The on-chip thermal sensors 157A may comprise one or more proportional to absolute temperature ("PTAT") temperature sensors that are based on vertical PNP structure and are usually dedicated to complementary metal oxide semiconductor ("CMOS") very large-scale integration ("VLSI") circuits. The off-chip thermal sensors 157B may comprise one or more thermistors. The thermal sensors 157 may produce a voltage drop that is converted to digital signals with an analog-to-digital converter ("ADC") controller (not shown). However, other types of thermal sensors 157 may be employed.

The touch screen display 132, the video port 138, the USB port 142, the camera 148, the first stereo speaker 154, the second stereo speaker 156, the microphone 160, the FM antenna 164, the stereo headphones 166, the RF switch 170, the RF antenna 172, the keypad 174, the mono headset 176, the vibrator 178, thermal sensors 157B, the PMIC 180 and the power supply 188 are external to the on-chip system 102. It will be understood, however, that one or more of these devices depicted as external to the on-chip system 102 in the exemplary embodiment of a PCD 100 in FIG. 9 may reside on chip 102 in other exemplary embodiments.

In a particular aspect, one or more of the method steps described herein may be implemented by executable instructions and parameters stored in the memory 112 or as form the MTT aggregator module 101 and/or the image CODEC module 113. Further, the MTT aggregator module 101, the image CODEC module 113, the memory 112, the instructions stored therein, or a combination thereof may serve as a means for performing one or more of the method steps described herein.

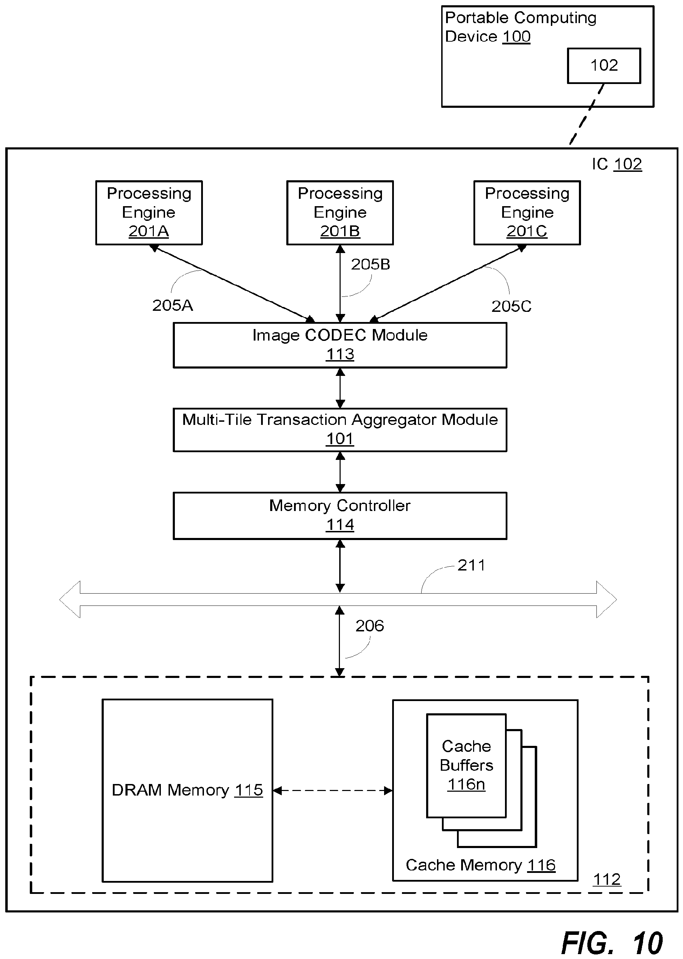

FIG. 10 is a functional block diagram illustrating an embodiment of an on-chip system 102 for managing compressed data stored in a DRAM component 115 using multi-tile transactions ("MTT"). As indicated by the arrows 205 in the FIG. 10 illustration, a processing engine 201 may be submitting transaction requests for either reading data from the DRAM 115 or writing data to the DRAM 115, or a combination thereof, via a system bus 211. As is understood by one of ordinary skill in the art, a processing engine 201, such as the CPU 110, in executing a workload could be fetching and/or updating instructions and/or data that are stored at the address(es) of the DRAM memory 115.

As the processing engines 201 generate data transfers for transmission via bus 211 to cache memory 116 and/or DRAM memory 115, the image CODEC module 113 may compress tile-sized units of an image frame, as would be understood by one of ordinary skill in the art. Subsequently, the MTT aggregator module 101 may seek to combine two or more of the compressed tiles into a single transaction and work with the memory controller 114 to make more efficient use of DRAM 115 capacity and bus 211 bandwidth. Using the metadata associated with a MTT transaction, the memory controller 114 may service access requests and/or write requests from the processing engines 201 for data stored in DRAM 115 according to an MTT transaction.

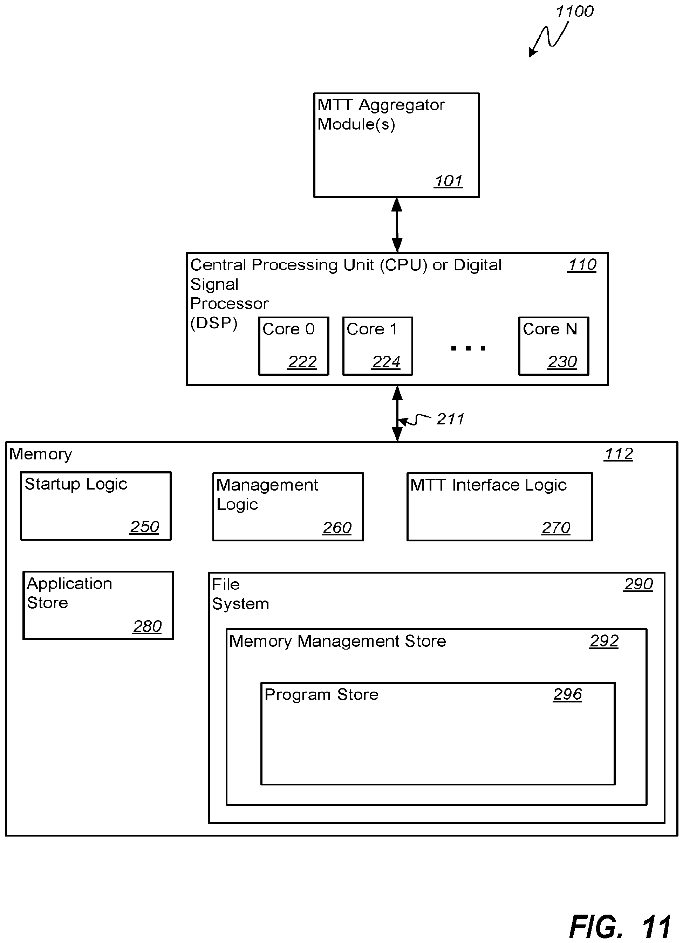

FIG. 11 is a schematic diagram illustrating an exemplary software architecture of the PCD of FIG. 9 for managing compressed data with multi-tile transactions. As illustrated in FIG. 11, the CPU or digital signal processor 110 is coupled to the memory 112 via main bus 211. The CPU 110, as noted above, is a multiple-core processor having N core processors. That is, the CPU 110 includes a first core 222, a second core 224, and an N^{th} core 230. As is known to one of ordinary skill in the art, each of the first core 222, the second core 224 and the N^{th} core 230 are available for supporting a dedicated application or program. Alternatively, one or more applications or programs may be distributed for processing across two or more of the available cores.

The CPU 110 may receive commands from the MTT aggregator module(s) 101 that may comprise software and/or hardware. If embodied as software, the module(s) 101 comprise instructions that are executed by the CPU 110 that issues commands to other application programs being executed by the CPU 110 and other processors.

The first core 222, the second core 224 through to the Nth core 230 of the CPU 110 may be integrated on a single integrated circuit die, or they may be integrated or coupled on separate dies in a multiple-circuit package. Designers may couple the first core 222, the second core 224 through to the N^{th} core 230 via one or more shared caches and they may implement message or instruction passing via network topologies such as bus, ring, mesh and crossbar topologies.

Bus 211 may include multiple communication paths via one or more wired or wireless connections, as is known in the art and described above in the definitions. The bus 211 may have additional elements, which are omitted for simplicity, such as controllers, buffers (caches), drivers, repeaters, and receivers, to enable communications. Further, the bus 211 may include address, control, and/or data connections to enable appropriate communications among the aforementioned components.

When the logic used by the PCD 100 is implemented in software, as is shown in FIG. 11, it should be noted that one or more of startup logic 250, management logic 260, MTT interface logic 270, applications in application store 280 and portions of the file system 290 may be stored on any computer-readable medium for use by, or in connection with, any computer-related system or method.

In the context of this document, a computer-readable medium is an electronic, magnetic, optical, or other physical device or means that may contain or store a computer program and data for use by or in connection with a computer-related system or method. The various logic elements and data stores may be embodied in any computer-readable medium for use by or in connection with an instruction execution system, apparatus, or device, such as a computer-based system, processor-containing system, or other system that can fetch the instructions from the instruction execution system, apparatus, or device and execute the instructions. In the context of this document, a "computer-readable medium" can be any means that can store, communicate, propagate, or transport the program for use by or in connection with the instruction execution system, apparatus, or device.

The computer-readable medium can be, for example but not limited to, an electronic, magnetic, optical, electromagnetic, infrared, or semiconductor system, apparatus, device, or propagation medium. More specific examples (a non-exhaustive list) of the computer-readable medium would include the following: an electrical connection (electronic) having one or more wires, a portable computer diskette (magnetic), a random-access memory (RAM) (electronic), a read-only memory (ROM) (electronic), an erasable programmable read-only memory (EPROM, EEPROM, or Flash memory) (electronic), an optical fiber (optical), and a portable compact disc read-only memory (CDROM) (optical). Note that the computer-readable medium could even be paper or another suitable medium upon which the program is printed, as the program can be electronically captured, for instance via optical scanning of the paper or other medium, then compiled, interpreted or otherwise processed in a suitable manner if necessary, and then stored in a computer memory.

In an alternative embodiment, where one or more of the startup logic 250, management logic 260 and perhaps the MTT interface logic 270 are implemented in hardware, the various logic may be implemented with any or a combination of the following technologies, which are each well known in the art: a discrete logic circuit(s) having logic gates for implementing logic functions upon data signals, an application specific integrated circuit (ASIC) having appropriate combinational logic gates, a programmable gate array(s) (PGA), a field programmable gate array (FPGA), etc.

The memory 112 is a non-volatile data storage device such as a flash memory or a solid-state memory device. Although depicted as a single device, the memory 112 may be a distributed memory device with separate data stores coupled to the digital signal processor 110 (or additional processor cores).

The startup logic 250 includes one or more executable instructions for selectively identifying, loading, and executing a select program for aggregating and managing multi-tile transactions. The startup logic 250 may identify, load and execute a select MTT program. An exemplary select program may be found in the program store 296 of the embedded file system 290. The exemplary select program, when executed by one or more of the core processors in the CPU 110 may operate in accordance with one or more signals provided by the MTT aggregator module 101 to create and manage multi-tile transactions.

The management logic 260 includes one or more executable instructions for terminating an MTT program on one or more of the respective processor cores, as well as selectively identifying, loading, and executing a more suitable replacement program. The management logic 260 is arranged to perform these functions at run time or while the PCD 100 is powered and in use by an operator of the device. A replacement program may be found in the program store 296 of the embedded file system 290.

The interface logic 270 includes one or more executable instructions for presenting, managing and interacting with external inputs to observe, configure, or otherwise update information stored in the embedded file system 290. In one embodiment, the interface logic 270 may operate in conjunction with manufacturer inputs received via the USB port 142. These inputs may include one or more programs to be deleted from or added to the program store 296. Alternatively, the inputs may include edits or changes to one or more of the programs in the program store 296. Moreover, the inputs may identify one or more changes to, or entire replacements of one or both of the startup logic 250 and the management logic 260. By way of example, the inputs may include a change to the number of compressed tiles that may be combined into a single MTT transaction and/or to the definition of a group of tiles eligible for aggregation into a single MTT transaction.

The interface logic 270 enables a manufacturer to controllably configure and adjust an end user's experience under defined operating conditions on the PCD 100. When the memory 112 is a flash memory, one or more of the startup logic 250, the management logic 260, the interface logic 270, the application programs in the application store 280 or information in the embedded file system 290 may be edited, replaced, or otherwise modified. In some embodiments, the interface logic 270 may permit an end user or operator of the PCD 100 to search, locate, modify or replace the startup logic 250, the management logic 260, applications in the application store 280 and information in the embedded file system 290. The operator may use the resulting interface to make changes that will be implemented upon the next startup of the PCD 100. Alternatively, the operator may use the resulting interface to make changes that are implemented during run time.

The embedded file system 290 includes a hierarchically arranged memory management store 292. In this regard, the file system 290 may include a reserved section of its total file system capacity for the storage of information for the configuration and management of the various MTT algorithms used by the PCD 100.

Certain steps in the processes or process flows described in this specification naturally precede others for the invention to function as described. However, the invention is not limited to the order of the steps described if such order or sequence does not alter the functionality of the invention. That is, it is recognized that some steps may performed before, after, or parallel (substantially simultaneously with) other steps without departing from the scope of the invention. In some instances, certain steps may be omitted or not performed without departing from the invention. Further, words such as "thereafter", "then", "next", etc. are not intended to limit the order of the steps. These words are simply used to guide the reader through the description of the exemplary method.

Additionally, one of ordinary skill in programming is able to write computer code or identify appropriate hardware and/or circuits to implement the disclosed invention without difficulty based on the flow charts and associated description in this specification, for example. Therefore, disclosure of a particular set of program code instructions or detailed hardware devices is not considered necessary for an adequate understanding of how to make and use the invention. The inventive functionality of the claimed computer implemented processes is explained in more detail in the above description and in conjunction with the drawings, which may illustrate various process flows.

In one or more exemplary aspects, the functions described may be implemented in hardware, software, firmware, or any combination thereof. If implemented in software, the functions may be stored on or transmitted as one or more instructions or code on a computer-readable medium. Computer-readable media include both computer storage media and communication media including any medium that facilitates transfer of a computer program from one place to another. A storage media may be any available media that may be accessed by a computer. By way of example, and not limitation, such computer-readable media may comprise RAM, ROM, EEPROM, CD-ROM or other optical disk storage, magnetic disk storage or other magnetic storage devices, or any other medium that may be used to carry or store desired program code in the form of instructions or data structures and that may be accessed by a computer.

Therefore, although selected aspects have been illustrated and described in detail, it will be understood that various substitutions and alterations may be made therein without departing from the scope of the present invention, as defined by the following claims.

## Claims

1. A method for managing compressed data transaction sizes in a system on a chip, "SoC", in a portable computing device, "PCD", **characterized in that** the method comprises:
determining lengths of compressed data tiles associated in a group, wherein the compressed data tiles are comprised within a compressed image file;
determining, based on the determined lengths, whether to aggregate the compressed data tiles into a single multi-tile transaction;
aggregating the compressed data tiles into a single multi-tile transaction in response to a determination to aggregate the compressed data tiles into a single multi-tile transaction if a sum of the lengths of the compressed data tiles is smaller than a footprint of one uncompressed data tile in a memory component;
generating a metadata file in association with the single multi-tile transaction, wherein the metadata file identifies the transaction as a multi-tile transaction and provides offset data to distinguish data associated with the compressed data tiles; and
writing the single multi-tile transaction to the memory component in a location representing a footprint of a first uncompressed data tile rather than to both the location representing the footprint of the first uncompressed data tile and a location representing the footprint of a second uncompressed data tile.

2. The method of claim 1, wherein the memory component is a double data rate memory component.

3. The method of claim 1, wherein the compressed data tiles were compressed according to a lossless compression algorithm.

4. The method of claim 1, wherein the group of tiles are sequential in a row of the compressed image file.

5. The method of claim 1, wherein the group of tiles are sequential in a column of the compressed image file.

6. The method of claim 1, wherein the group of tiles are contiguous in an area of the compressed image file.

7. A system for managing compressed data transaction sizes in a system on a chip, "SoC", in a portable computing device, "PCD", characterized that the system comprises:
means for determining lengths of compressed data tiles associated in a group, wherein the compressed data tiles are comprised within a compressed image file;
means for determining, based on the determined lengths, whether to aggregate the compressed data tiles into a single multi-tile transaction;
means for aggregating the compressed data tiles into a single multi-tile transaction in response to a determination to aggregate the compressed data tiles into a single multi-tile transaction if a sum of the lengths of the compressed data tiles is smaller than a footprint of one uncompressed data tile in a memory component;
means for generating a metadata file in association with the single multi-tile transaction, wherein the metadata file identifies the transaction as a multi-tile transaction and provides offset data to distinguish data associated with the compressed data tiles; and
means for writing the single multi-tile transaction to the memory component in a location representing a footprint of a first uncompressed data tile rather than to both the location representing the footprint of the first uncompressed data tile and a location representing the footprint of a second uncompressed data tile.

8. The system of claim 7, wherein the memory component is a double data rate memory component.

9. The system of claim 7, wherein the compressed data tiles were compressed according to a lossless compression algorithm.

10. The system of claim 7, wherein the group of tiles are sequential in a row of the compressed image file; or
wherein the group of tiles are sequential in a column of the compressed image file.

11. A computer program comprising code to perform the method of any of the claims 1 to 6 when executed on a computer.

## Patentansprüche

1. Verfahren zum Verwalten komprimierter Datentransaktionsgrößen in einem system on a chip, SoC, in einem portable computer device, PCD, **dadurch gekennzeichnet, dass** das Verfahren umfasst:
Bestimmen der Längen von komprimierten Datenkacheln, die in einer Gruppe verbunden sind, wobei die komprimierten Datenkacheln in einer komprimierten Bilddatei enthalten sind;
Bestimmen, basierend auf den bestimmten Längen, ob die komprimierten Datenkacheln zu einer einzigen Multi-Kachel-Transaktion aggregiert werden sollen;
Aggregieren der komprimierten Datenkacheln zu einer einzelnen Multi-Kachel-Transaktion als Reaktion auf eine Bestimmung, die komprimierten Datenkacheln zu einer einzelnen Multi-Kachel-Transaktion zu aggregieren, wenn eine Summe der Längen der komprimierten Datenkacheln kleiner ist als ein Fußabdruck einer unkomprimierten Datenkachel in einer Speicherkomponente;
Erzeugen einer Metadatendatei in Verbindung mit der einzelnen Multi-Kachel-Transaktion, wobei die Metadatendatei die Transaktion als eine Multi-Kachel-Transaktion identifiziert und Offset-Daten bereitstellt, um Daten zu unterscheiden, die mit den komprimierten Datenkacheln verbunden sind; und
Schreiben der einzelnen Multi-Kachel-Transaktion in die Speicherkomponente an einer Stelle, die den Fußabdruck einer ersten unkomprimierten Datenkachel repräsentiert, anstatt sowohl an die Stelle, die den Fußabdruck der ersten unkomprimierten Datenkachel repräsentiert, als auch an eine Stelle, die den Fußabdruck einer zweiten unkomprimierten Datenkachel repräsentiert.

2. Verfahren nach Anspruch 1, wobei die Speicherkomponente eine Speicherkomponente mit doppelter Datenrate ist.

3. Verfahren nach Anspruch 1, wobei die komprimierten Datenkacheln nach einem verlustfreien Kompressionsalgorithmus komprimiert wurden.

4. Verfahren nach Anspruch 1, wobei die Gruppe von Kacheln in der komprimierten Bilddatei in einer Reihe aufeinanderfolgend angeordnet ist.

5. Verfahren nach Anspruch 1, wobei die Gruppe von Kacheln in einer Spalte der komprimierten Bilddatei aufeinanderfolgend angeordnet ist.

6. Verfahren nach Anspruch 1, wobei die Gruppe von Kacheln in einem Bereich der komprimierten Bilddatei aneinander angrenzend sind.

7. System zur Verwaltung komprimierter Datentransaktionsgrößen in einem System on a Chip, SoC, in einem portable computing device, PCD, **dadurch gekennzeichnet, dass** das System umfasst:
Mittel zum Bestimmen der Längen von komprimierten Datenkacheln, die in einer Gruppe verbunden sind, wobei die komprimierten Datenkacheln in einer komprimierten Bilddatei enthalten sind;
Mittel zum Bestimmen, basierend auf den bestimmten Längen, ob die komprimierten Datenkacheln zu einer einzigen Multi-Kachel-Transaktion aggregiert werden sollen;
Mittel zum Aggregieren der komprimierten Datenkacheln zu einer einzelnen Multi-Kachel-Transaktion als Reaktion auf eine Bestimmung, die komprimierten Datenkacheln zu einer einzelnen Multi-Kachel-Transaktion zu aggregieren, wenn eine Summe der Längen der komprimierten Datenkacheln kleiner ist als ein Fußabdruck einer unkomprimierten Datenkachel in einer Speicherkomponente;
Mittel zum Erzeugen einer Metadatendatei in Verbindung mit der einzelnen Multi-Kachel-Transaktion, wobei die Metadatendatei die Transaktion als eine Multi-Kachel-Transaktion identifiziert und Offset-Daten bereitstellt, um Daten,
die mit den komprimierten Datenkacheln verbunden sind, zu unterscheiden; und
Mittel zum Schreiben der einzelnen Multi-Kachel-Transaktion in die Speicherkomponente an einer Stelle, die einen Fußabdruck einer ersten unkomprimierten Datenkachel repräsentiert, anstatt sowohl an die Stelle, die den Fußabdruck der ersten unkomprimierten Datenkachel repräsentiert, als auch an eine Stelle, die den Fußabdruck einer zweiten unkomprimierten Datenkachel repräsentiert.

8. System nach Anspruch 7, wobei die Speicherkomponente eine Speicherkomponente mit doppelter Datenrate ist.

9. System nach Anspruch 7, bei dem die komprimierten Datenkacheln nach einem verlustfreien Kompressionsalgorithmus komprimiert wurden.

10. System nach Anspruch 7, wobei die Gruppe von Kacheln in einer Reihe der komprimierten Bilddatei aufeinanderfolgend angeordnet sind; oder
wobei die Gruppe von Kacheln in einer Spalte der komprimierten Bilddatei aufeinanderfolgend sind.

11. Computerprogramm, umfassend Code zum Durchführen des Verfahrens nach einem der Ansprüche 1 bis 6, wenn es auf einem Computer ausgeführt wird.

## Revendications

1. Un procédé pour gérer des tailles de transaction de données compressées dans un système sur puce, "SoC", dans un dispositif informatique portable, "PCD", **caractérisé en ce que** le procédé comprend :
la détermination de longueurs de tuiles de données compressées associées dans un groupe, dans lequel les tuiles de données compressées sont comprises à l'intérieur d'un fichier d'image compressé ;
la détermination, sur la base des longueurs déterminées, s'il faut agréger les tuiles de données compressées en une unique transaction multi-tuile ;
l'agrégation des tuiles de données compressées en une unique transaction multi-tuile en réponse à une détermination d'agréger les tuiles de données compressées en une unique transaction multi-tuile si une somme des longueurs des tuiles de données compressées est inférieure à une étendue d'une tuile de données non compressée dans un composant de mémoire ;
la génération d'un fichier de métadonnées en association avec l'unique transaction multi-tuile, dans lequel le fichier de métadonnées identifie la transaction comme étant une transaction multi-tuile et fournit des données de décalage pour distinguer les données associées aux tuiles de données compressées ; et
l'écriture de l'unique transaction multi-tuile dans le composant de mémoire en un emplacement représentant une étendue d'une première tuile de données non compressée plutôt que vers à la fois l'emplacement représentant l'étendue de la première tuile de données non compressée et un emplacement représentant l'étendue d'une seconde tuile de données non compressée.

2. Le procédé selon la revendication 1, dans lequel le composant de mémoire est un composant de mémoire à double débit de données.

3. Le procédé selon la revendication 1, dans lequel les tuiles de données compressées ont été compressées selon un algorithme de compression sans perte.

4. Le procédé selon la revendication 1, dans lequel le groupe de tuiles est séquentiel dans une rangée du fichier d'image compressé.

5. Le procédé selon la revendication 1, dans lequel le groupe de tuiles est séquentiel dans une colonne du fichier d'image compressé.

6. Le procédé selon la revendication 1, dans lequel le groupe de tuiles est contigu dans une zone du fichier d'image compressé.

7. Un système pour gérer des tailles de transaction de données compressées dans un système sur puce, "SoC", dans un dispositif informatique portable, "PCD", **caractérisé en ce que** le système comprend :
des moyens pour déterminer des longueurs de tuiles de données compressées associées dans un groupe, dans lequel les tuiles de données compressées sont comprises à l'intérieur d'un fichier d'image compressé ;
des moyens pour déterminer, sur la base des longueurs déterminées, s'il faut agréger les tuiles de données compressées en une unique transaction multi-tuile ;
des moyens pour agréger les tuiles de données compressées en une unique transaction multi-tuile en réponse à une détermination d'agréger les tuiles de données compressées en une unique transaction multi-tuile si une somme des longueurs des tuiles de données compressées est inférieure à une étendue d'une tuile de données non compressée dans un composant de mémoire ;
des moyens pour générer un fichier de métadonnées en association avec l'unique transaction multi-tuile, dans lequel le fichier de métadonnées identifie la transaction comme étant une transaction multi-tuile et fournit des données de décalage pour distinguer les données associées aux tuiles de données compressées ; et
des moyens pour écrire l'unique transaction multi-tuile dans le composant de mémoire en un emplacement représentant une étendue d'une première tuile de données non compressée plutôt que vers à la fois l'emplacement représentant l'étendue de la première tuile de données non compressée et un emplacement représentant l'étendue d'une seconde tuile de données non compressée.

8. Le système selon la revendication 7, dans lequel le composant de mémoire est un composant de mémoire à double débit de données.

9. Le système selon la revendication 7, dans lequel les tuiles de données compressées ont été compressées selon un algorithme de compression sans perte.

10. Le système selon la revendication 7, dans lequel le groupe de tuiles est séquentiel dans une rangée du fichier d'image compressé ; ou
dans lequel le groupe de tuiles est séquentiel dans une colonne du fichier d'image compressé.

11. Un programme informatique comprenant du code pour mettre en œuvre le procédé selon l'une des revendications 1 à 6, lorsqu'il est exécuté sur un ordinateur.
